(19) Europäisches Patentamt
European Patent Office
Office européen des brevets

(11) **EP 2 721 428 B1**

(12) **FASCICULE DE BREVET EUROPEEN**

(45) Date de publication et mention de la délivrance du brevet:
**18.03.2015 Bulletin 2015/12**

(21) Numéro de dépôt: **12732569.4**

(22) Date de dépôt: **14.06.2012**

(51) Int Cl.:
***G01R 31/36*** (2006.01)

(86) Numéro de dépôt international:
**PCT/EP2012/061383**

(87) Numéro de publication internationale:
**WO 2012/172030 (20.12.2012 Gazette 2012/51)**

(54) **DISPOSITIF DE SURVEILLANCE D'UNE BATTERIE D'ACCUMULATION ELECTRIQUE ET PROCEDE ASSOCIE**

GERÄT UND VERFAHREN ZUR ÜBERWACHUNG EINER AKKUMULATORBATTERIE

DEVICE AND PROCEDURE FOR MONITORING A RECHARGEABLE BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.06.2011 FR 1155218**

(43) Date de publication de la demande:
**23.04.2014 Bulletin 2014/17**

(73) Titulaires:
• **Compagnie Générale des Etablissements Michelin**
**63000 Clermont-Ferrand (FR)**
• **Michelin Recherche et Technique S.A.**
**1763 Granges-Paccot (CH)**

(72) Inventeurs:
• **PAGANELLI, Gino**
**F-63040 Clermont-Ferrand Cedex 09 (FR)**
• **AUGUET, Thierry**
**F-63040 Clermont-Ferrand Cedex 09 (FR)**

(74) Mandataire: **Ribière, Joel**
**M.F.P. Michelin,**
**SGD/LG/PI - F35 - Ladoux**
**23, place des Carmes-Déchaux**
**63040 Clermont-Ferrand Cedex 9 (FR)**

(56) Documents cités:
**WO-A1-2011/067646      CA-A1- 2 448 277**
**JP-A- 2005 345 124**

**Description**

L'invention se rapporte au domaine de la gestion des batteries d'alimentation électrique.

Une batterie d'alimentation électrique est généralement constituée d'un ensemble de cellules individuelles connectées en série. Chaque cellule individuelle peut comprendre un groupe d'éléments électrochimiques élémentaires, eux-mêmes connectés entre eux en série ou en parallèle. L'arrangement des éléments électrochimique est identique à l'intérieur de chaque cellule individuelle.

Afin d'éviter un emballement des réactions chimiques, une batterie peut être équipée d'un système chargé de surveiller individuellement chaque cellule de la batterie. Ce système, généralement désigné par l'acronyme « BMS » (« Battery Management System ») est configuré pour mesurer la tension individuelle de chaque cellule, mesurer le courant sortant de la batterie, calculer l'état de charge de la batterie, surveiller le niveau de température à l'intérieur de la batterie, et équilibrer les tensions des différentes cellules individuelles.

L'équilibrage peut notamment se faire après une étape de charge de la batterie, en déchargeant à l'aide d'une résistance les cellules dont le niveau de charge serait sensiblement supérieur à celui des autres cellules.

Certaines batteries, par exemple les batteries au lithium, sont particulièrement intolérantes à des excursions en tension ou en température, en dehors de certaines limites prédéfinies.

La surveillance en température de la batterie est généralement assurée à l'aide de sondes de température, judicieusement réparties dans la batterie pour donner une information globale sur la température.

Pour des raisons de coût des sondes et de l'électronique associée, une sonde est généralement prévue pour surveiller plusieurs cellules individuelles.

Un tel arrangement peut dans certains cas amener à une non détection d'une défaillance ayant conduit à un échauffement très local d'une cellule justement située à distance d'une sonde de température.

Un tel échauffement local peut ensuite se répercuter en un évènement thermique de grande amplitude sur l'ensemble de la batterie, voire un emballement thermique, et une explosion.

Le document CA 2 448 277 décrit un dispositif de calcul d'une capacité de stockage d'une batterie électrique, configuré pour effectuer des cycles spécifiques de charge ou de décharge de la batterie, ces cycles étant effectués à courant constant en dehors des cycles de la batterie directement prévus pour réalimenter la batterie ou pour alimenter des consommateur à partir de la batterie. Le différentiel de tension entre le début et la fin du cycle spécifique permet ensuite de calculer une résistance interne de chaque cellule de la batterie. Cette résistance interne est ensuite utilisée pour estimer la capacité de stockage de la batterie. Ce dispositif ne permet pas de surveiller l'état de la batterie pendant l'utilisation principale de la batterie pour laquelle la batterie a été conçue, par exemple pendant l'utilisation de la batterie sur un véhicule se déplaçant sur la route.

Le document WO 2011/067646 décrit un dispositif de surveillance d'une batterie effectuant un échantillonnage dans le temps de mesures de tensions de cellules de batterie et un échantillonnage de mesures de courant de batterie. Les mesures de tension sont comparées directement à une tension de référence, et un message d'alerte est transmis à une unité centrale si la tension est inférieure à une tension seuil, afin de ne pas stocker toutes les valeurs de tension. Quand le courant de batterie franchit un seuil supérieur, on conclut à une augmentation de résistance interne de la batterie. Ce dispositif ne permet pas de tenir compte, dans le calcul de la résistance interne de la cellule, d'une évolution de la tension à vide de la cellule surveillée avec l'état de charge de la cellule.

L'invention a pour but de prévenir l'échauffement local au niveau d'une des cellules de la batterie, sans augmenter le coût de l'équipement nécessaire à la surveillance de la batterie.

A cet effet, l'invention propose la mise en place d'un système de surveillance apte à détecter l'augmentation anormale de la résistance interne d'une cellule individuelle de la batterie, ou une défaillance de contact entre deux cellules. Cette surveillance est mise en place en utilisant les capteurs déjà présents pour alimenter en données le système de surveillance (BMS) de la batterie.

Ainsi, un dispositif selon l'invention de surveillance d'une batterie d'accumulation électrique comprenant un ensemble de cellules connectées en série, comprend :

- un moyen de mesure de l'intensité de courant délivrée par la batterie,
- un moyen de mesure d'une tension électrique entre un point de connexion amont et un point de connexion aval de chaque cellule,
- un enregistreur de la tension électrique à courant nul entre le même point de connexion amont et le même point de connexion aval de chaque cellule, et
- un estimateur de résistance électrique, configuré pour estimer de manière périodique la résistance électrique de chaque cellule entre son point de connexion amont et son point de connexion aval.

Avantageusement, l'estimateur de résistance électrique comprend une mémoire dans laquelle est stockée une résistance moyenne de l'ensemble des cellules, et un comparateur de résistance apte à comparer la résistance de chaque cellule à la résistance moyenne de l'ensemble des cellules, et configuré pour délivrer un signal d'alerte si la valeur absolue de la différence entre une résistance d'une des cellules et la résistance moyenne dépasse un premier seuil.

Avantageusement, l'estimateur de résistance électrique est configuré pour estimer de manière périodique permanente la résistance électrique de chaque cellule durant tout le temps où la batterie est sollicitée en charge ou en décharge.

Autrement dit, l'estimation périodique est effectuée sur toute la durée des périodes de temps où la batterie est sollicitée en charge ou en décharge.

On peut ainsi détecter une défaillance d'une des cellules, ou une défaillance d'une connexion entre cellules, à tout moment durant l'utilisation de la batterie.

Dans ce mode de réalisation préférentiel, l'estimation a lieu en particulier pendant des phases de recharge de la batterie par freinage récupératif si la batterie est installée sur un véhicule électrique configuré pour pratiquer ce type de freinage, et a lieu en tout été de cause pendant les phases de recharge de la batterie sur un réseau électrique fixe. L'estimation a également lieu pendant toute phase où la batterie débite dans un ou plusieurs consommateurs, quel que soit le type de consommateurs branchés sur la batterie.

Dans un autre mode de réalisation, le contrôle de la résistance interne des cellules de la batterie peut être effectué la majeure partie des périodes où la batterie est sollicitée en charge ou en décharge, en excluant quelques périodes de fonctionnement transitoires où par exemple les fluctuations de courant ou de tension pourraient générer des erreurs de mesures conduisant à un diagnostic erroné.

Selon un mode de réalisation préférentiel, l'estimateur de résistance électrique est configuré pour comparer la résistance de chaque cellule à une résistance de référence, et pour délivrer un signal d'alerte si la différence entre une résistance d'une des cellules et la résistance de référence dépasse un second seuil.

L'enregistreur des tensions à courant nul peut-être configuré pour actualiser les valeurs enregistrées à chaque fois que le courant de la batterie s'annule. On considère que le courant de la batterie s'annule si sa valeur absolue devient inférieure à une valeur seuil de courant, par exemple inférieure à 0,1 A, ou de préférence inférieure à 0,01 A.

L'enregistreur des tensions à courant nul peut en outre être configuré pour activer un signal de péremption si les valeurs enregistrées n'ont pas été actualisées depuis une période supérieure à une période minimale d'actualisation.

Selon une autre variante de réalisation, l'enregistreur des tensions à courant nul peut être configuré pour activer un signal de péremption si, depuis que les valeurs enregistrées ont été actualisées, l'état de charge de la batterie a augmenté ou a diminué d'une valeur supérieure à une fraction seuil d'état de charge.

Avantageusement, l'enregistreur de tension à courant nul est configuré pour activer une variable booléenne de péremption en fonction de la date de dernière actualisation des tensions à courant nul, et, quand la variable de péremption est activée, l'estimateur de résistance électrique est configuré pour comparer la résistance de chaque cellule uniquement à la résistance moyenne de l'ensemble des cellules.

Le dispositif peut comprendre un dispositif de synchronisation apte à synchroniser chaque série de mesures des tensions entre le point de connexion amont et le point de connexion aval des différentes cellules, avec une mesure d'intensité du courant sortant de la batterie.

Selon un autre aspect, une batterie est équipée d'un dispositif tel que décrit précédemment. Dans cette batterie, le point de connexion amont pour la mesure de tension d'une cellule est également le point de connexion aval pour la mesure de tension d'une cellule adjacente dans la série, sauf pour deux cellules d'extrémité de la batterie.

Avantageusement, entre chaque point de connexion amont et chaque point de connexion aval, on trouve le même nombre de cellules élémentaires et le même nombre d'éléments de connexion résistifs entre cellules.

Selon encore un autre aspect, dans un procédé de surveillance des cellules d'une batterie d'accumulation électrique, on mesure périodiquement la tension entre un point de connexion amont et un point de connexion aval de chaque cellule de la batterie, on mesure simultanément l'intensité de courant sortant de la batterie, et on calcule une résistance associée à la cellule entre le point de connexion amont et le point de connexion aval, en divisant le différentiel de tension par rapport à une tension à courant nul, par l'intensité sortant de la batterie.

De manière préférentielle, on compare de manière périodique la résistance de chaque cellule à une résistance moyenne de l'ensemble des cellules, et on délivre un signal d'alerte si la valeur absolue de la différence entre une résistance d'une des cellules et la résistance moyenne dépasse un premier seuil.

Avantageusement, on réestime les valeurs de tension à courant nul de chaque cellule à chaque fois que le courant de la batterie s'annule.

Selon un mode de réalisation préférentiel, on active une variable booléenne de péremption si les valeurs de tension à courant nul n'ont pas été actualisées depuis une période supérieure à une période minimale d'actualisation.

Selon un autre mode de réalisation avantageux, on active une variable booléenne de péremption si, depuis que les valeurs de tension à courant nul ont été actualisées, l'état de charge de la batterie a augmenté ou a diminué d'une valeur supérieure à une fraction seuil d'état de charge.

D'autres buts, caractéristiques et avantages de l'invention apparaîtront à la lecture de la description suivante, donnée uniquement à titre d'exemple non limitatif, et faite en référence aux dessins annexés, sur lesquels :

- la figure 1 est une représentation schématique simplifiée d'une batterie d'accumulation électrique équipée d'un système de surveillance selon l'invention,
- la figure 2 est un exemple d'algorithme de surveillance d'une batterie équipée d'un système de surveillance selon l'invention, et
- la figure 3 est une variante de l'algorithme de surveillance de la figure 2.

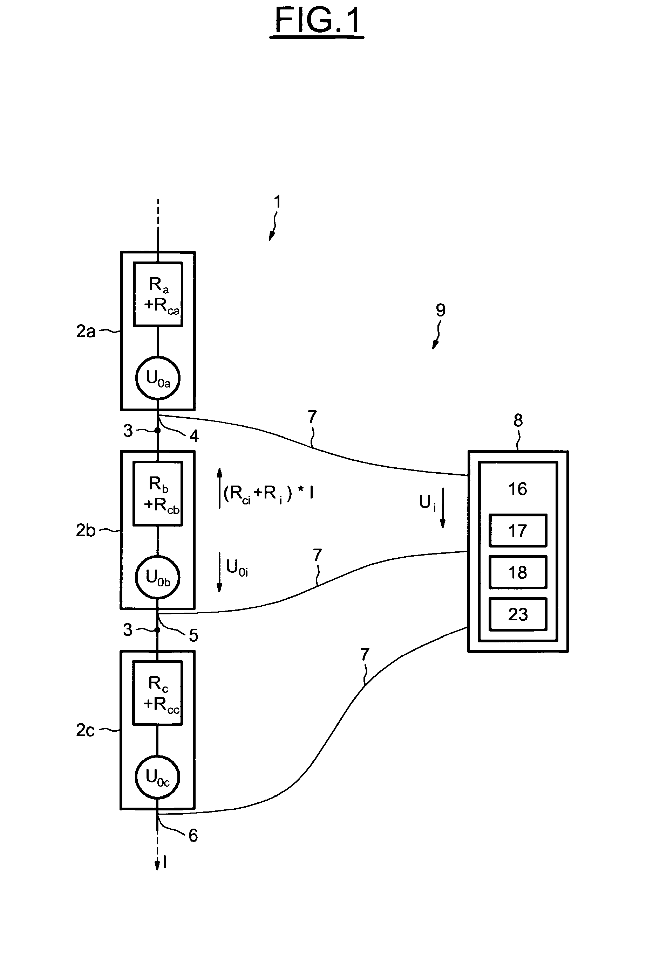

Tel qu'illustré sur la figure 1, une batterie 1 comprend des cellules $2_a$, $2_b$ et $2_c$...reliées entre elles par des éléments de connexion 3. La batterie 1 est équipée d'un dispositif de surveillance 9 comprenant une unité de commande électronique 8, et des connexions 7 reliant pour chaque cellule, un point de connexion amont de la cellule, par exemple ici pour la cellule $2_b$, le point 4, et un point de connexion aval de la cellule, ici pour la cellule $2_b$ le point 5.

L'unité de commande électronique 8 comprend un enregistreur 17 de tensions à courant nul, un estimateur de résistances 16, un comparateur de résistances 18, et une mémoire 23 de stockage d'une valeur de résistance moyenne.

La définition de l'amont et de l'aval d'une cellule s'entend ici, est dans la suite du texte, comme un amont et un aval défini par rapport à la direction de circulation d'un courant I à l'intérieur de la batterie, quand la batterie fournit de l'énergie électrique à un circuit extérieur.

La batterie 1 délivre ou reçoit un courant I qui est le courant qui traverse chacune des cellules $2_a$, $2_b$, $2_c$...A tout instant, chaque cellule peut être caractérisée par une tension $U_i$, ici $U_a$, $U_b$, $U_c$... entre son point de connexion amont et son point de connexion aval. Dans le même état de charge, chaque cellule peut être caractérisée par une tension à vide ou tension à courant nul $U_{0i}$, ici $U_{0a}$, $U_{0b}$, $U_{0c}$... qui est la tension qui s'établit entre le point de connexion amont et le point de connexion aval si l'on interrompt le circuit électrique extérieur branché entre les deux bornes de la batterie 1.

L'unité de commande électronique 8 comporte des moyens de mesure permettant de déterminer pour chaque cellule, par exemple pour la cellule $2_b$, entre son point de connexion amont 4 et son point de connexion aval 5, la tension $U_i$.

L'unité de commande électronique 8 comporte également un moyen de mesure lui permettant de déterminer l'intensité I entrant ou sortant de la batterie 1, sensiblement au même moment qu'elle effectue une série de mesures de tension, soit une mesure de tension $U_i$ pour chaque cellule. L'unité de commande électronique 8 comporte à cet effet des moyens de synchronisation lui permettant d'effectuer de manière périodique, une série d'acquisitions de toutes les tensions $U_i$ des différentes cellules constituant la batterie 1, ainsi qu'au moins une acquisition d'intensité de courant effectuée sensiblement au même moment que sont effectuées les acquisitions des valeurs de tension.

Un seul point de connexion est disposé entre chaque couple de cellules contiguës, si bien que le point de connexion amont d'une cellule, par exemple ici le point 4 pour la cellule $2_b$, est en même temps un point de connexion aval pour une autre cellule, ici pour la cellule $2_a$. De manière similaire, la cellule $2_c$ comporte ici un point de connexion amont 5 qui est en même temps le point de connexion aval de la cellule $2_b$, et la cellule $2_c$ comporte elle-même un point de connexion aval 6.

L'enregistreur 17 de tension à courant nul est configuré pour mémoriser les valeurs $U_{0a}$, $U_{0b}$, $U_{0c}$, ...$U_i$...mesuré entre le point de connexion amont et le point de connexion aval de chaque cellule à chaque fois que le courant I de la batterie s'annule.

La résistance d'une cellule entre son point amont et son point aval varie en fonction de l'état électrochimique de la cellule et est la somme d'un premier terme $R_i$ (ici $R_a$, $R_b$, $R_c$...) représentant la résistance interne du ou des éléments électrochimiques aptes à délivrer l'énergie électrique produite par la cellule, et d'un terme $R_{ci}$ (ici $R_{ca}$, $R_{cb}$, $R_{cc}$...) représentant la résistance des éléments de connexion 3 permettant de relier les différentes cellules entre elles, et qui sont interposés entre le point amont de mesure de la tension et le point aval de mesure de la tension de la cellule.

Une augmentation de la résistance interne $R_i + R_{ci}$ d'une cellule peut provenir soit d'un évènement électrochimique, ce qui se traduit par une augmentation du terme $R_i$, soit d'un défaut de contact entre deux cellules voisines, ce qui se traduit par une augmentation du terme $R_{ci}$.

La résistance interne d'une cellule i, incluant le terme électrochimique $R_i$ et le terme de contact $R_{ci}$, est égale à :

$$\left(R_i + R_{ci}\right) = \frac{U_{0i} - U_i}{I} \qquad \text{Equation (1)}$$

A partir des valeurs $U_i$, $U_{0i}$ et I acquises par l'unité de commande électronique 8, l'estimateur de résistances 16 évalue la résistance $R_i+R_{ci}$ de chaque cellule selon l'équation (1), et transmet cette valeur au comparateur de résistances 18, qui vérifie si la résistance calculée reste comprise dans des bornes définies comme acceptables.

Une valeur moyenne des résistances $R_i+R_{ci}$ peut être calculée pour chaque campagne de mesure d'une tension pour chaque cellule. Cette valeur moyenne : $\langle R_j + R_{cj} \rangle_{j=1,n}$

peut par exemple être obtenue soit en faisant une moyenne des résistances estimées pour chaque cellule suite à une seule mesure de tension pour chaque cellule, peut être une valeur moyenne filtrée sur plusieurs acquisitions de tension pour chaque cellule.

La résistance d'une cellule peut par exemple être jugée comme acceptable si, d'une part, elle reste inférieure à une valeur seuil $R_{max}$, et si d'autre part, cette résistance de la cellule reste suffisamment proche d'une valeur moyenne $\langle R_j + R_{cj} \rangle_{j=1,n}$ obtenue en faisant une moyenne des résistances de toutes les cellules mesurées au même moment. $R_{max}$, peut par exemple être définie à partir d'une résistance interne maximale probable d'une cellule et d'une résistance maximale de contact acceptable entre cellules.

On peut ainsi définir une condition de conformité de la résistance comme une variable booléenne Conf qui s'écrit sous la forme :

$$Conf(R_i + R_{ci}) = 1 \quad si \quad \left| (R_i + R_{ci}) - \langle R_j + R_{cj} \rangle_{j=1,n} \right| \le A \qquad \text{Equation (2)}$$

$$et \ si \quad R_i + R_{ci} \le R_{max}$$

Conf $(R_i + R_{ci})$ est une variable booléenne qui est alors positive si la résistance de la cellule I est jugée normale.

La valeur $U_{0i}$ représentant la tension à vide de chaque cellule, est liée à l'état de charge de la cellule. Elle répond à des mécanismes de polarisation relativement lents, mais doit être réévaluée régulièrement. Un critère de péremption flag($U_0$) peut lui être associé, qui indique que les valeurs calculées à partir des valeurs $U_{0i}$ mémorisées risquent d'être entachées d'erreur. Ce critère de péremption flag($U_0$) peut être par exemple défini comme une variable booléenne qui devient positive si le courant I n'est pas passé par zéro pendant une période de temps supérieure à une période minimale, ou si ce passage par zéro du courant I n'a pas été suffisamment long pour permettre d'effectuer une acquisition des tensions à vide $U_{0i}$ de toutes les cellules.

L'activation de l'indicateur de péremption flag($U_0$) peut également se faire, en complément, ou indépendamment de la surveillance du temps écoulé depuis la dernière actualisation des valeurs $U_{0i}$, en surveillant l'amplitude de la variation de l'état de charge de la batterie depuis la dernière actualisation des valeurs $U_{0i}$.

A cet effet, différents estimateurs d'état de charge de la batterie peuvent être utilisés, qui sont connus de l'état de l'art, et qui cherchent généralement à représenter la valeur théorique <SOC (State Of Charge) répondant à l'équation :

$$\frac{d(SOC)}{dt} = -\frac{I}{Q}$$

où t est le temps,
I est le courant sortant dans la batterie,
et Q est la capacité de la batterie à l'instant t, en Ah (ampère.heure).

Un indicateur de péremption flag($U_0$) peut par exemple être défini de la manière suivante, si la dernière actualisation de toutes les tensions $U_{0i}$ a eu lieu à un instant $t_{actu}$,

$$flag(U_0) = 1$$

$$si \quad t - t_{actu} > \Delta t$$

$$ou \ si \quad \left| SOC(t) - SOC(t_{actu}) \right| > \Delta SOC_1 \qquad \text{Equation (3)}$$

$$ou \ si \quad \int_{tactu}^{t} \left| dSOC(u) \right| du > \Delta SOC_2$$

où $\Delta t$ est un seuil de durée, $\Delta SOC_1$ et $\Delta SOC_2$ sont des seuils de variation d'état de charge.

On peut retenir comme critère de péremption l'une des trois conditions énumérées ci-dessus ou l'alternative entre deux des trois conditions, ou l'alternative entre les trois conditions.

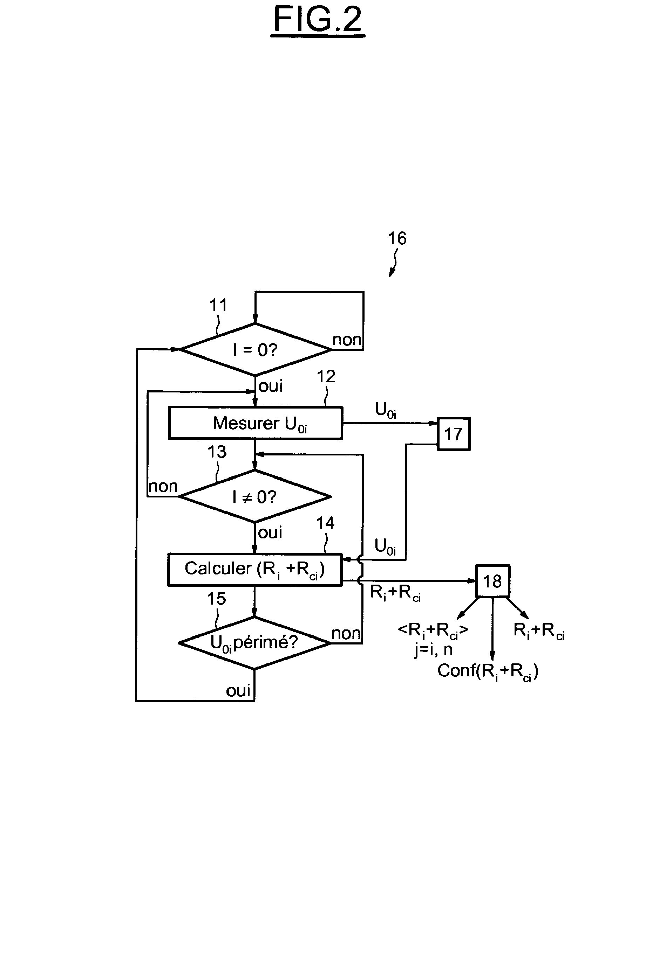

La figure 2 illustre un mode de fonctionnement possible de l'estimateur de résistance 16 de l'unité de commande électronique 8.

On retrouve sur la figure 2 quelques références communes à la figure 1, les mêmes éléments étant alors désignés par les mêmes références. Lors d'une mise en service de la batterie, lors du branchement de la batterie sur le dispositif de surveillance 9, l'estimateur de résistance 16 se place d'abord dans une boucle d'attente 11 tant que le courant I de la batterie 1 ne passe pas par zéro.

Quand le courant I de la batterie passe par zéro, l'estimateur de résistance 16 effectue une série d'acquisitions des valeurs $U_{0i}$ des tensions aux bornes des différentes cellules de la batterie et les transmet à l'enregistreur 17 des tensions à courant nul. On peut pour ce faire considérer que le courant I de la batterie passe par zéro, quand la valeur absolue du courant I est inférieure à un seuil de courant $I_{zero}$, soit $|I| \leq I_{zero}$. Après avoir effectué cette acquisition à une étape 12, l'estimateur de résistances 16 effectue des tests 13 pour savoir si le courant I de la batterie est devenue différent de zéro, c'est-à-dire $|I| > I_{zero}$. Si tel n'est pas le cas, l'estimateur de résistances 16 réitère l'étape 12, réactualise les valeurs $U_{0i}$ de tension à vide des différentes cellules et les renvoie vers l'enregistreur 17.

Quand, suite au test 13, un courant I non nul est détecté, l'estimateur de résistances 16 effectue à une étape 14, une acquisition des tensions $U_i$ entre les points amont et aval de toutes les cellules, et calcule pour chaque cellule i sa résistance interne $R_i + R_{ci}$. Il transmet alors au comparateur de résistances 18 l'ensemble des valeurs de résistance $R_i + R_{ci}$ ainsi calculées.

L'estimateur de résistances 16 effectue alors à une étape 15 un test de péremption pour savoir si les valeurs de tensions à vide mémorisées par l'enregistreur de tensions à courant nul sont encore pertinentes. Le test de péremption 15 peut correspondre à l'activation d'une variable booléenne flag($U_0$) selon les conditions de l'équation (3), par exemple.

Si la variable de péremption est activée, c'est-à-dire si le groupe de valeurs $U_{0i}$ est considéré comme périmé, l'estimateur de résistances 16 revient à l'étape 11 et attend une nouvelle annulation du courant I, puis reprend dans l'ordre les étapes 12, 13 et suivantes.

L'enregistreur de tensions 17 reçoit à l'étape 12 les valeurs de tensions à vide de différentes cellules, et les restitue à l'étape 14 pour permettre de calculer les valeurs $R_i + R_{ci}$ selon l'équation (1). Le comparateur de résistances 18 mémorise l'ensemble des résistances $R_i + R_{ci}$ calculées suite à une campagne d'acquisition de valeurs $U_i$ des différentes cellules, ou, suivant les variantes de réalisation, mémorise les valeurs $R_i + R_{ci}$ des résistances calculées suite à plusieurs campagnes d'acquisition des valeurs de tensions $U_i$ entre les points amont et aval de toutes cellules. Une fois que les valeurs $R_i + R_{ci}$ correspondant à toutes les cellules ont été mémorisées pour au moins une campagne d'acquisition, le comparateur de résistances 18 calcule une valeur moyenne $\left\langle R_j + R_{cj} \right\rangle_{j=1,n}$ de ces résistances et les stocke dans la mémoire 23. Le comparateur de résistances 18 peut alors calculer une variable booléenne de conformité Conf($R_i + R_{ci}$) pour chaque cellule de la batterie, par exemple selon l'équation (2), et émettre un signal d'alerte si l'une au moins de ces variables de conformité est négative. Le comparateur de résistance peut transmettre à d'autres unités de contrôle (non représentées), soit toutes les valeurs de résistance calculées, soit uniquement une valeur de résistance anormale quand une telle valeur anormale est détectée par la fonction Conf($R_i + R_{ci}$).

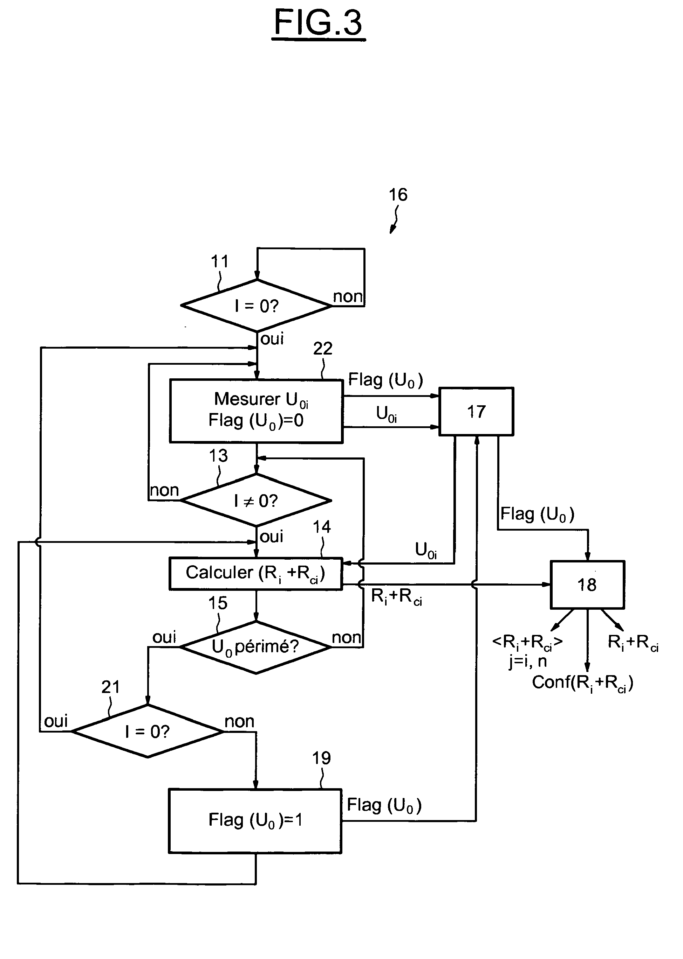

La figure 3 illustre une variante de mode de fonctionnement de l'estimateur de résistances 16. On retrouve sur la figure 3 des éléments communs aux figures 1 et 2, les mêmes éléments étant alors désignés par les mêmes références. Comme sur la figure 2, l'estimateur de résistances 16 commence par se mettre dans une boucle d'attente jusqu'à ce que l'intensité I s'annule à une étape 11. L'estimateur 16 effectue alors une campagne d'acquisition $U_{0i}$ à une étape 22, et quand il a terminé cette campagne d'acquisition, il désactive l'indicateur de péremption flag($U_0$). Il transmet alors à l'enregistreur de tensions 17 la valeur de l'indicateur de péremption $U_0$ et les valeurs de tensions à vide de l'ensemble des cellules de la batterie.

Il effectue alors un test 13 pour savoir si le courant I est devenu non nul. Dans la négative, il réitère l'étape 22. Quand le courant I devient non nul, l'estimateur de résistances 16 effectue à une étape 14 une série d'acquisitions des tensions $U_i$ entre les points amont et aval de toutes les cellules de la batterie, et calcule les résistances $R_i + R_{ci}$ correspondantes, puis les transmet au comparateur de résistances 18.

Il effectue alors le test de péremption 15, par exemple selon l'équation (3). Si le test 15 indique que les valeurs de tensions à vide sont périmées, l'estimateur de résistances 16 effectue un test 21 pour savoir si l'intensité de courant I est nulle. Si ce courant I est nul ou environ nul, soit $|I| \leq I_{zero}$, l'estimateur réitère l'étape 22 d'acquisition des tensions à vide des différentes cellules, et désactive l'indicateur de péremption flag (Uo).

Si le courant I n'est pas nul, l'estimateur de résistances 16 transmet à une étape 19 la valeur activée de l'indicateur de péremption à l'enregistreur de tensions 17, et passe à l'étape 14 où il effectue une campagne d'acquisition des tensions entre les points amont et les points aval de toutes les cellules de la batterie. L'estimateur de résistance en déduit les résistances $R_i+R_{ci}$ de toutes les cellules, sur la base des valeurs $U_{0i}$ disponibles auprès de l'enregistreur de tensions 17; il transmet ces valeurs $R_i+R_{ci}$ au comparateur de résistances 18, qui reçoit en parallèle la valeur de l'indicateur de péremption flag($U_0$) à partir de l'enregistreur de tensions 17.

Malgré l'activation de l'indicateur de péremption, le comparateur de résistances 18 peut donc effectuer un test de conformité sur l'ensemble des valeurs $R_i+R_{ci}$ calculées à partir de la dernière campagne d'acquisition des tensions entre les points amont et aval des différentes cellules. Le comparateur de résistances 18 applique un test de conformité qui peut éventuellement être différent selon la valeur de l'indicateur de péremption flag($U_0$). Si l'indicateur de péremption est activé, le comparateur peut être programmé pour comparer chaque valeur de résistances des cellules uniquement à la résistance moyenne des cellules $\left\langle R_j + R_{cj} \right\rangle_{j=1,n}$ calculée lors de la même campagne d'acquisition et stockées dans la mémoire 23, sans comparer ces résistances à une valeur absolue $R_{max}$.

L'objet de l'invention ne se limite pas aux exemples de réalisation décrits et peut faire l'objet de nombreuses variantes, notamment en ce qui concerne l'expression du critère de péremption, l'expression du critère de conformité des résistances internes des cellules, ou la composition de chaque cellule entre un point de connexion amont et un point de connexion aval. On peut choisir, pour le critère de conformité, de surveiller le gradient de variation de chaque résistance de cellule, et le comparer à un gradient maximal acceptable.

Chaque cellule individuelle peut ainsi comprendre plusieurs éléments électrochimiques et plusieurs éléments de contact montés, soit en série, soit en parallèle, mais disposés de manière identiques d'une cellule à l'autre.

Le dispositif de surveillance selon l'invention permet ainsi, en utilisant des capteurs déjà présents dans le système de surveillance de la batterie, de surveiller de manière individuelle les risques de surchauffe de chaque cellule, et d'identifier une cause de surchauffe avant même que soit mesurable une élévation sensible de température de la cellule. Grâce à la réestimation régulière de la tension à courant nul, cette surveillance est effectuée en continu pendant le fonctionnement normal de la batterie, sans nécessiter de cycles de charge ou de décharge spécifiques à la méthode de surveillance. Un mode de fonctionnement dégradé est prévu pour permettre de poursuivre la surveillance sans générer d'alertes inutiles si la tension à courant nul risque temporairement de ne plus être pertinente.

En outre, ce système de surveillance est peu ou pas influencé par la température ambiante de la batterie.

## Revendications

1. Dispositif de surveillance d'une batterie d'accumulation électrique comprenant un ensemble de cellules (2a, 2b, 2c) connectées en série, le dispositif comprenant :

   - un moyen de mesure de l'intensité de courant (I) délivrée par la batterie,
   - un moyen de mesure d'une tension électrique ($U_i$) entre un point de connexion amont et un point de connexion aval de chaque cellule (2a, 2b, 2c) **caractérisé en ce que** le dispositif (9) comprend en outre :
   - un enregistreur (17) de la tension électrique à courant nul ($U_{0i}$) configuré pour enregistrer la tension entre le même point de connexion amont et le même point de connexion aval de chaque cellule (2a, 2b, 2c), à chaque fois que le courant (I) de la batterie (1) s'annule et
   - un estimateur de résistance électrique (16), configuré pour estimer de manière périodique la résistance électrique ($R_i+R_{ci}$) de chaque cellule (2a, 2b, 2c), entre son point de connexion amont et son point de connexion aval.

2. Dispositif selon la revendication 1, dans lequel l'estimateur de résistance électrique (16) comprend une mémoire (23) dans laquelle est stockée une résistance moyenne ($\langle R_j+R_{cj}\rangle$) de l'ensemble des cellules, et un comparateur de résistance (18) apte à comparer la résistance de chaque cellule ($R_i+R_{ci}$) à la résistance moyenne ($\langle R_j+R_{cj}\rangle$) de l'ensemble des cellules, et configuré pour délivrer un signal d'alerte si la valeur absolue de la différence entre une résistance d'une des cellules et la résistance moyenne ($\langle R_j+R_{cj}\rangle$) dépasse un premier seuil.

3. Dispositif selon les revendications 1 ou 2, dans lequel l'estimateur de résistance électrique (16) est configuré pour comparer la résistance de chaque cellule ($R_i+R_{ci}$) à une résistance de référence, et pour délivrer un signal d'alerte si la différence entre une résistance d'une des cellules et la résistance de référence dépasse un second seuil.

4. Dispositif selon la revendication 3 dépendante de la revendication 2, dans lequel l'enregistreur de tension à courant nul (17) est configuré pour activer une variable booléenne de péremption (flag($U_0$)) en fonction de la date de dernière actualisation des tensions à courant nul ($U_{0i}$), et, quand la variable de péremption est activée, l'estimateur de résistance électrique (16) est configuré pour comparer la résistance de chaque cellule ($R_i+R_{ci}$) uniquement à la résistance moyenne ($\langle R_j+R_{cj}\rangle$) de l'ensemble des cellules.

5. Dispositif selon l'une des revendications précédentes, comprenant un dispositif de synchronisation apte à synchroniser chaque série de mesures des tensions ($U_i$) entre le point de connexion amont et le point de connexion aval des différentes cellules (2a, 2b, 2c), avec une mesure d'intensité de courant (I) sortant de la batterie (1).

6. Dispositif selon l'une des revendications précédentes, dans lequel l'estimateur de résistance électrique (16) est configuré pour estimer de manière périodique permanente la résistance électrique ($R_i+R_{ci}$) de chaque cellule (2a, 2b, 2c) durant tout le temps où la batterie est sollicitée en charge ou en décharge.

7. Batterie d'accumulation électrique équipée d'un dispositif selon l'une des revendications précédentes, dans laquelle le point de connexion amont (4, 5) pour la mesure de tension d'une cellule est également le point de connexion aval pour la mesure de tension d'une cellule adjacente dans la série, sauf pour deux cellules d'extrémité de la batterie (1).

8. Batterie selon la revendication précédente, dans laquelle, entre chaque point de connexion amont et chaque point de connexion aval, on trouve le même nombre de cellules élémentaires et le même nombre d'éléments de connexion résistifs(3) entre cellules.

9. Procédé de surveillance des cellules (2a, 2b, 2c) d'une batterie d'accumulation électrique, dans lequel on mesure périodiquement la tension ($U_i$) entre un point de connexion amont et un point de connexion aval de chaque cellule de la batterie, on mesure simultanément l'intensité de courant (I) sortant de la batterie, et on calcule une résistance ($R_i+R_{ci}$) associée à la cellule entre le point de connexion amont et le point de connexion aval, en divisant le différentiel de tension ($U_i$) par rapport à une tension à courant nul ($U_{0i}$), par l'intensité (I) sortant de la batterie, la valeur de tension à courant nul ($U_{0i}$) de chaque cellule (2a, 2b, 2c) étant réestimée à chaque fois que le courant (I) de la batterie (1) s'annule.

10. Procédé selon la revendication 9, dans lequel on compare de manière périodique la résistance ($R_i+R_{ci}$) de chaque cellule à une résistance moyenne ($\langle R_j+R_{cj}\rangle$) de l'ensemble des cellules, et on délivre un signal d'alerte si la valeur absolue de la différence entre une résistance d'une des cellules et la résistance moyenne dépasse un premier seuil.

11. Procédé selon l'une des revendications 8 à 10, dans lequel on active une variable booléenne de péremption (flag($U_0$)) si les valeurs de tension à courant nul ($U_{0i}$) n'ont pas été actualisées depuis une période supérieure à une période minimale d'actualisation.

12. Procédé selon l'une des revendications 8 à 10, dans lequel on active une variable booléenne de péremption (flag($U_0$)) si, depuis que les valeurs de tension à courant nul ($U_{0i}$) ont été actualisées, l'état de charge de la batterie a augmenté ou a diminué d'une valeur supérieure à une fraction seuil d'état de charge.

**Patentansprüche**

1. Vorrichtung zum Überwachen einer elektrischen Akkumulatorbatterie, die eine Gesamtheit von in Reihe geschalteten Zellen (2a, 2b, 2c) enthält, wobei die Vorrichtung Folgendes umfasst:

- ein Mittel zum Messen der Stärke des von der Batterie gelieferten Stroms (I),
- ein Mittel zum Messen einer elektrischen Spannung ($U_i$) zwischen einem stromaufseitigen Verbindungspunkt und einem stromabseitigen Verbindungspunkt jeder Zelle (2a, 2b, 2c), **dadurch gekennzeichnet, dass** die Vorrichtung (9) außerdem Folgendes umfasst:
- eine Einrichtung (17) zum Aufzeichnen der elektrischen Spannung ($U_{0i}$) bei Nullstrom, die konfiguriert ist, die Spannung zwischen demselben stromaufseitigen Verbindungspunkt und demselben stromabseitigen Verbindungspunkt jeder Zelle (2a, 2b, 2c) jedes Mal aufzuzeichnen, wenn der Strom (I) der Batterie (1) null wird, und
- eine Einrichtung (16) zum Schätzen des elektrischen Widerstands, die konfiguriert ist, den elektrischen Widerstand ($R_i + R_{ci}$) jeder Zelle (2a, 2b, 2c) zwischen ihrem stromaufseitigen Verbindungspunkt und ihrem stromabseitigen Verbindungspunkt periodisch zu schätzen.

2. Vorrichtung nach Anspruch 1, wobei die Einrichtung (16) zum Schätzen des elektrischen Widerstands einen Speicher (23), in dem ein mittlerer Widerstand ($<R_j + R_{cj}>$) der Gesamtheit von Zellen gespeichert ist, und einen Widerstandskomparator (18), der den Widerstand jeder Zelle ($R_i + R_{ci}$) mit dem mittleren Widerstand ($<R_j + R_{cj}>$) der Gesamtheit von Zellen vergleichen kann und konfiguriert ist, ein Warnsignal auszugeben, wenn der Absolutwert der Differenz zwischen einem Widerstand einer der Zellen und dem mittleren Widerstand ($<R_j + R_{cj}>$) einen ersten Schwellenwert überschreitet, umfasst.

3. Vorrichtung nach den Ansprüchen 1 oder 2, wobei die Einrichtung (16) zum Schätzen des elektrischen Widerstands konfiguriert ist, den Widerstand jeder Zelle ($R_i + R_{ci}$) mit einem Referenzwiderstand zu vergleichen und ein Warnsignal auszugeben, falls die Differenz zwischen einem Widerstand einer der Zellen und dem Referenzwiderstand einen zweiten Schwellenwert überschreitet.

4. Vorrichtung nach Anspruch 3, wenn abhängig von Anspruch 2, wobei die Einrichtung (17) zum Aufzeichnen einer Spannung bei Nullstrom konfiguriert ist, eine boolsche Verfallsvariable ($flag(U_0)$) als Funktion des Datums der letzten Aktualisierung der Spannungen ($U_{0i}$) bei Nullstrom zu aktivieren, wobei die Einrichtung (16) zum Schätzen des elektrischen Widerstands konfiguriert ist, dann, wenn die Verfallsvariable aktiviert ist, den Widerstand jeder Zelle ($R_i + R_{ci}$) ausschließlich mit dem mittleren Widerstand ($<R_j + R_{cj}>$) der Gesamtheit von Zellen zu vergleichen.

5. Vorrichtung nach einem der Ansprüche, die eine Synchronisationsvorrichtung umfasst, die jede Reihe von Messungen der Spannungen ($U_i$) zwischen dem stromaufseitigen Verbindungspunkt und dem stromabseitigen Verbindungspunkt der verschiedenen Zellen (2a, 2b, 2c) mit einer Messung der Stärke des aus der Batterie (1) austretenden Stroms (I) synchronisieren kann.

6. Vorrichtung nach einem der vorhergehenden Ansprüche, wobei die Einrichtung (16) zum Schätzen des elektrischen Widerstands konfiguriert ist, den elektrischen Widerstand ($R_i + R_{ci}$) jeder Zelle (2a, 2b, 2c) während der gesamten Zeit, in der die Batterie erzwungen geladen oder entladen wird, ständig periodisch zu schätzen.

7. Elektrische Akkumulatorbatterie, die mit einer Vorrichtung nach einem der vorhergehenden Ansprüche ausgerüstet ist, wobei der stromaufseitige Verbindungspunkt (4, 5) für die Messung der Spannung einer Zelle auch der stromabseitige Verbindungspunkt für die Messung der Spannung einer benachbarten Zelle in der Reihe mit Ausnahme der zwei letzten Zellen der Batterie (1) ist.

8. Batterie nach dem vorhergehenden Anspruch, wobei zwischen jedem stromaufseitigen Verbindungspunkt und jedem stromabseitigen Verbindungspunkt die gleiche Anzahl von Elementarzellen und die gleiche Anzahl von resistiven Verbindungselementen (3) zwischen Zellen vorhanden sind.

9. Verfahren zum Überwachen von Zellen (2a, 2b, 2c) einer elektrischen Akkumulatorbatterie, wobei die Spannung ($U_i$) zwischen einem stromaufseitigen Verbindungspunkt und einem stromabseitigen Verbindungspunkt jeder Zelle der Batterie periodisch gemessen wird, gleichzeitig die Stärke des aus der Batterie austretenden Stroms (I) gemessen wird und ein Widerstand ($R_i + R_{ci}$), der der Zelle zwischen dem stromaufseitigen Verbindungspunkt und dem stromabseitigen Verbindungspunkt zugeordnet ist, berechnet wird, indem das Differential der Spannung ($U_i$) in Bezug auf eine Spannung ($U_{0i}$) bei Nullstrom durch die die Batterie verlassende Stärke (I) dividiert wird, wobei der Wert der Spannung ($U_{0i}$) bei Nullstrom jeder Zelle (2a, 2b, 2c) jedes Mal neu geschätzt wird, wenn der Strom (I) der Batterie (1) null wird.

10. Verfahren nach Anspruch 9, wobei periodisch der Widerstand ($R_i + R_{ci}$) jeder Zelle mit einem mittleren Widerstand ($<R_j + R_{cj}>$) der Gesamtheit von Zellen verglichen wird und ein Warnsignal ausgegeben wird, falls der Absolutwert der Differenz zwischen einem Widerstand einer der Zellen und dem mittleren Widerstand einen ersten Schwellenwert überschreitet.

11. Verfahren nach einem der Ansprüche 8 bis 10, wobei eine boolsche Verfallsvariable ($flag(U_0)$) aktiviert wird, falls die Spannungswerte ($U_{0i}$) bei Nullstrom seit einer Periode, die größer als eine minimale Aktualisierungsperiode ist, nicht aktualisiert worden sind.

12. Verfahren nach einem der Ansprüche 8 bis 10, wobei eine boolsche Verfallsvariable ($flag(U_0)$) aktiviert wird, falls sich seit der Aktualisierung der Spannungswerte ($U_{0i}$) bei Nullstrom der Ladezustand der Batterie um einen Wert größer als ein Schwellenbruchteil des Ladezustands erhöht oder erniedrigt hat.

**Claims**

1. Device for monitoring an electrical accumulation battery comprising a set of cells (2a, 2b, 2c) connected in series, the device comprising:

   - a means for measuring the current intensity (I) delivered by the battery,
   - a means for measuring an electrical voltage ($U_i$) between an upstream connection point and a downstream connection point of each cell (2a, 2b, 2c), **characterized in that** the device (9) also comprises:
   - a recorder (17) of the zero-current electrical voltage ($U_{0i}$) configured to record the voltage between the same upstream connection point and the same downstream connection point of each cell (2a, 2b, 2c), each time the current (I) from the battery (1) is cancelled and
   - an electrical resistance estimator (16), configured to periodically estimate the electrical resistance ($R_i+R_{ci}$) of each cell (2a, 2b, 2c), between its upstream connection point and its downstream connection point.

2. Device according to Claim 1, in which the electrical resistance estimator (16) comprises a memory (23) in which an average resistance ($\langle R_j+R_{cj} \rangle$) of the set of cells is stored, and a resistance comparator (18) suitable for comparing the resistance of each cell ($R_i+R_{ci}$) to the average resistance ($\langle R_j+R_{cj} \rangle$) of the set of cells, and configured to deliver an alert signal if the absolute value of the difference between a resistance of one of the cells and the average resistance ($\langle R_j+R_{cj} \rangle$) exceeds a first threshold.

3. Device according Claims 1 or 2, in which the electrical resistance estimator (16) is configured to compare the resistance of each cell ($R_i+R_{ci}$) to a reference resistance, and to deliver an alert signal if the difference between a resistance of one of the cells and the reference resistance exceeds a second threshold.

4. Device according to Claim 3, being dependant on claim 2, in which the zero current voltage recorder (17) is configured to activate a pre-emption Boolean variable (flag($U_0$)) as a function of the date of the last updating of the zero-current voltages ($U_{0i}$), and, when the pre-emption variable is activated, the electrical resistance estimator (16) is configured to compare the resistance of each cell ($R_i+R_{ci}$) only to the average resistance ($\langle R_j+R_{cj} \rangle$) of the set of cells.

5. Device according to one of the preceding claims, comprising a synchronisation device suitable for synchronising each series of measurements of the voltages ($U_i$) between the upstream connection point and the downstream connection point of the different cells (2a, 2b, 2c), with a measurement of current intensity (I) outgoing from the battery (1).

6. Device according to one of the preceding claims, in which the electrical resistance estimator (16) is configured to permanently periodically estimate the electrical resistance ($R_i+R_{ci}$) of each cell (2a, 2b, 2c) throughout the time when the battery is being used in charge or discharge mode.

7. Electrical accumulation battery equipped with a device according to one of the preceding claims, in which the upstream connection point (4, 5) for measuring the voltage of a cell is also the downstream connection point for measuring the voltage of an adjacent cell in the series, except for two end cells of the battery (1).

8. Battery according to the preceding claim, in which, between each upstream connection point and each downstream connection point, there are the same number of elementary cells and the same number of resistive connection elements (3) between cells.

9. Method for monitoring the cells (2a, 2b, 2c) of an electrical accumulation battery, in which the voltage ($U_i$) between an upstream connection point and a downstream connection point of each cell of the battery is periodically measured, the current intensity (I) outgoing from the battery is simultaneously measured, and a resistance ($R_i+R_{ci}$) associated with the cell between the upstream connection point and the downstream connection point is calculated by dividing the voltage differential ($U_i$) relative to a zero-current voltage ($U_{0i}$), by the intensity (I) outgoing from the battery, the zero-current voltage value ($U_{0i}$) of each cell (2a, 2b, 2c) being reestimated each time the current (I) from the battery (1) is cancelled.

10. Method according to Claim 9, in which the resistance ($R_i+R_{ci}$) of each cell is periodically compared to an average resistance ($\langle R_j+R_{cj} \rangle$) of the set of cells, and an alert signal is delivered if the absolute value of the difference between a resistance of one of the cells and the average resistance exceeds a first threshold.

**11.** Method according to one of Claims 8 to 10, in which a pre-emption Boolean variable (flag($U_0$)) is activated if the zero-current voltage values ($U_{0i}$) have not been updated for a period greater than a minimum updating period.

**12.** Method according to one of Claims 8 to 10, in which a pre-emption Boolean variable (flag($U_0$)) is activated if, since the zero-current voltage values ($U_{0i}$) have been updated, the state of charge of the battery has increased or decreased by a value greater than a state-of-charge threshold fraction.

# FIG.1

$$(R_{ci} + R_i) * I$$

$$U_{0i}$$

$$U_i$$

# FIG.2

# FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CA 2448277
- WO 2011067646 A